(19) Europäisches Patentamt
European Patent Office
Office européen des brevets

(11) **EP 3 032 268 B1**

(12) **EUROPEAN PATENT SPECIFICATION**

(45) Date of publication and mention
of the grant of the patent:
**28.03.2018 Bulletin 2018/13**

(21) Application number: **14196982.4**

(22) Date of filing: **09.12.2014**

(51) Int Cl.:
*G01R 15/20* *(2006.01)*      *G01R 33/07* *(2006.01)*
*G01R 33/00* *(2006.01)*

(54) **An integrated circuit with an on chip hall sensor**

Integrierte Schaltung mit einem On-Chip-Hall-Sensor

Circuit intégré avec un capteur de Hall sur puce

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.06.2016 Bulletin 2016/24**

(73) Proprietor: **Rohm Co., Ltd.**
**Kyoto-shi, Kyoto 615-8585 (JP)**

(72) Inventor: **Mladenova, Irina**
**Ukyo-ku, Kyoto 615-8585 (JP)**

(74) Representative: **Isarpatent**
**Patent- und Rechtsanwälte Behnisch Barth
Charles
Hassa Peckmann & Partner mbB
Friedrichstrasse 31
80801 München (DE)**

(56) References cited:
US-A- 5 023 684      US-A1- 2006 061 350
US-A1- 2006 152 210      US-A1- 2009 001 964

• AHMED F ABD EL-HALIM ET AL: "Practical
methodology of control and protection of field
oriented induction machine using digital signal
processing", COMPUTER THEORY AND
APPLICATIONS (ICCTA), 2012 22ND
INTERNATIONAL CONFERENCE ON, IEEE, 13
October 2012 (2012-10-13), pages 122-126,
XP032419062, DOI: 10.1109/ICCTA.2012.6523557
ISBN: 978-1-4673-2823-4

**Description**

FIELD OF THE INVENTION

The invention relates to an integrated circuit comprising at least one on chip Hall sensor plate adapted to measure an external and an internal magnetic field.

TECHNICAL BACKGROUND

A Hall sensor chip can be used for measuring or sensing an external magnetic field. The measured magnetic field can be a constant or alternating magnetic field. A Hall sensor is a transducer element that can vary its output voltage in response to an applied magnetic field. The Hall Effect comprises the generation of a voltage difference across an electrical conductor, transverse to an electric current in the conductor and a magnetic field being perpendicular to the electrical current.

If a steady electrical current I passes through an electrical conductor wire of an inductance or coil, a magnetic field is generated, wherein the strength of the magnetic field is linear dependent on the amplitude of the electrical current flowing through the wire as described in the Biot-Savart law. The Biot-Savart law describes the magnetic field generated by an electrical current. It relates the magnetic field to the magnitude, direction, length and proximity of the electrical current. The Hall voltage appearing at the electrodes of a Hall sensor is linear dependent on the magnetic field strength of the magnetic field applied to the Hall sensor. The Hall voltage depends on the electric current I and the applied magnetic field B as follows:

$$V_H = -\frac{I \cdot B}{nte},$$

where I is the electric current across the plate length of the Hall sensor plate, B is the applied magnetic field, t is the thickness of the Hall sensor plate, e is the elementary charge, and n is the charge carrier density of the carrier electrons.
A review for field oriented control induction machines which also discloses hall-effect voltage sensor terminals is known from A. El-Halim et al, "Practical Methodology of Control and Protection of Field Oriented Induction Machine Using Digital Signal Processing", Computer Theory and Applications, 2012, pages 122-126. A sensor arrangement for measuring current is disclosed in document US 2009/0001964 A1. US 2006/0061350 A1 describes an inverted magnetic isolator. From document US 5 023 684 A, a composite semiconductor device having a function for overcurrent detection is known. From US7075287 a Hall sensor for current sensing is known, were the sensing circuitry is protected by an overcurrent sensor comprising a controller for actuating a switch for interrupting the current flowing through the current conductor. Conventional Hall sensor chips are used for measurement or sensing an external constant or alternating magnetic field. By keeping the distance between the Hall sensor and the magnetic field source, such as a conductor or an inductance, and their orientation constant and by also keeping the electric current passed through the Hall sensor plate constant, the amplitude of the flowing electrical current forming the magnetic field source can be measured. However, keeping the distance and orientation constant is often difficult or even impossible. Conventional Hall sensor chips do not allow to measure the amplitude of electrical currents directly.

Accordingly, it is an object of the present invention to provide an integrated circuit allowing to measure the amplitude of an electrical current directly.

SUMMARY OF THE INVENTION

This object is achieved according to a first aspect of the present invention by an integrated circuit having the features of claim 1. This object is further achieved according to a second aspect of the present invention by an integrated circuit having the features of claim 12.

Accordingly, the integrated circuit according to the present invention provides a current sensing functionality to the integrated circuit.

The advantage of the integrated circuit according to the present invention is that the measurement of the applied electric current can be measured very precisely, since the distance between the chip conductor element and the on chip Hall sensor plate is very small and exactly defined by the internal structure of the integrated circuit.

In a possible embodiment of the integrated circuit according to the present invention, the on chip inductor element comprises a rectangular form.

In a still further possible embodiment of the integrated circuit according to the present invention, the on chip inductor element comprises a spiral form.

In a further possible embodiment of the integrated circuit according to the present invention, the on chip inductor element and the Hall sensor plate are provided at different layers of the integrated circuit providing a predetermined distance between the on chip inductor element and the Hall sensor plate.

In a further possible embodiment of the integrated circuit according to the present invention, an overcurrent protection circuit is connected in series with the at least one on chip inductor element.

In a further possible embodiment of the integrated circuit according to the second aspect of the present invention, if the voltage drop at the current sensing element exceeds a threshold voltage, the voltage amplifier switches the low resistance switch off to interrupt a current flow through said on chip inductor element.

In a further possible embodiment of the integrated circuit according to the present invention, the threshold voltage comprises a predetermined fixed threshold voltage.

In a further possible embodiment of the integrated circuit according to the present invention, the threshold voltage comprises an adjustable and/or programmable threshold voltage.

In a further possible embodiment of the integrated circuit according to the present invention, the current sensing element of the overcurrent protection circuit comprises an integrated resistor.

In a further possible embodiment of the integrated circuit according to the first aspect of the present invention, the on chip Hall sensor plate is implemented by a N-well cross structure placed in a p-type silicon substrate of the integrated circuit.

In a further possible embodiment of the integrated circuit according to the first aspect of the present invention, the on chip Hall sensor plate comprises four highly doped n+ contact areas connected to an interconnection metal layer of said integrated circuit isolated by an isolating layer from the p-type silicon substrate of said integrated circuit.

In a further possible embodiment of the integrated circuit according to the first aspect of the present invention, the on chip inductor element is formed by a metal planar coil on a passivation layer covering the on chip Hall sensor plate and the interconnection metal layer.

In a further possible embodiment of the integrated circuit according to the present invention, the on chip inductor element is bonded to chip frame pads of the integrated circuit.

In a further possible alternative embodiment of the integrated circuit, the on chip inductor element is connected to an on chip metal interconnection layer by means of via contacts.

In a still further possible embodiment of the integrated circuit according to the present invention, the on chip Hall sensor plate is configured to generate a Hall voltage being linear dependent on the magnetic field strength of the magnetic field caused by the electrical current flowing through said on chip inductor element.

In a further possible embodiment of the integrated circuit according to the present invention, the generated Hall voltage is processed to evaluate the electrical current flowing through the on chip inductor element of said integrated chip.

BRIEF DESCRIPTION OF THE FIGURES

In the following, possible embodiments of the integrated circuit are described in more detail with reference to the enclosed figures.

Fig. 1    shows a circuit diagram for illustrating a possible exemplary embodiment of an integrated circuit according to the present invention;

Fig. 2    shows a top view on a possible embodiment of an on chip inductor element as used by the integrated circuit according to the present invention;

Fig. 3    shows a cross-section view through an exemplary embodiment of an integrated circuit according to the present invention comprising an on chip inductor element as illustrated in Fig. 2.

DETAILED DESCRIPTION OF EMBODIMENTS

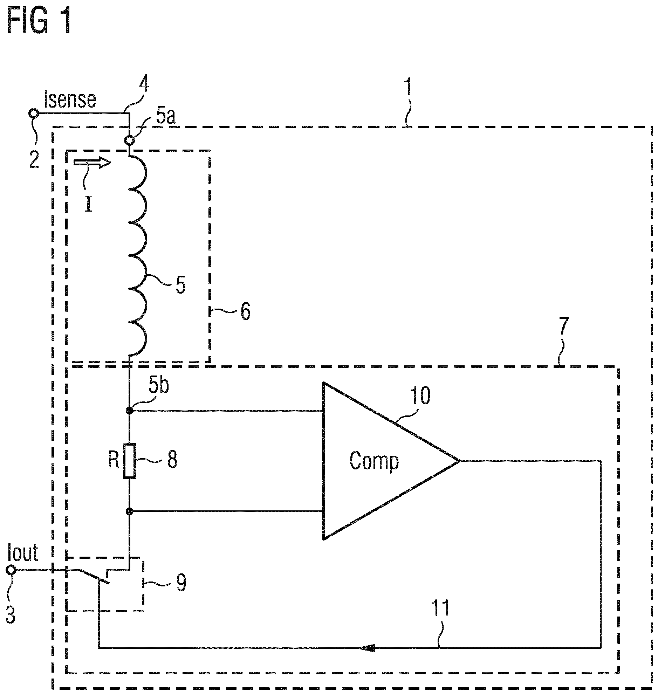

Fig. 1 shows a circuit diagram of an exemplary embodiment of an integrated circuit 1 according to the present invention. The integrated circuit 1 comprises a first current sense pin 2 and a second current sense pin 3 which can be connected to an external electronic circuit for measuring an electric current flowing from the first current sense pin 2 through the integrated circuit 1 to the second current sense pin 3. In the embodiment shown in Fig. 1, the first current sense pin 2 is connected via an internal current line 4 to an integrated on chip inductor element 5 placed in the vicinity of an integrated on chip Hall sensor plate 6 of the integrated circuit 1. In a possible embodiment, the on chip inductor element 5 and the Hall sensor plate 6 are provided at different layers of the integrated circuit 1. This implementation provides a predetermined distance between the on chip inductor element 5 and the Hall sensor plate 6. In a possible embodiment, the Hall sensor plate 6 is located in another layer of the integrated chip beneath the on chip inductor element 5. The on chip inductor element 5 is an electric coil formed by an on chip inductor. This on chip inductor element 5 can be formed by a top or other metal layer of the integrated circuit 1. The coil or on chip inductor element 5 can comprise a rectangular or a spiral form and can have one or more turns in the same or different metal layers of the integrated circuit 1. The on chip inductor element 5 is configured to generate an internal magnetic field which is sensed by the on chip Hall sensor plate 6 for measuring the electric current I flowing through the on chip inductor element 5 via the current sense pins 2, 3 of the integrated circuit 1. The electric current I flowing through the on chip inductor element 5 generates a magnetic field B which is sensed directly by the Hall sensor plate 6 of the integrated circuit 1. The distance and the orientation of the on chip inductor element 5 creating the magnetic field and the Hall sensor plate 6 is kept always fixed. Because of the linear dependencies described above, after calibration, the electric current I passing through the on chip inductor element 5 can be directly converted in a linear dependent voltage at the output of the on chip Hall sensor plate 6. The Hall voltage generated by the on chip Hall sensor plate 6 can in a possible embodiment be directly applied to corresponding pins of the integrated circuit 1. In an alternative embodiment, the generated output voltage can be further processed internally by a processing unit of the integrated circuit 1. If no electric current I passes through the on chip inductor element 5, the on chip Hall sensor plate 6 is adapted to measure an external magnetic field caused by an electrical current flowing through another external wire located in the vicinity of the integrated chip 1. Accordingly, the on chip Hall sensor plate 6 is adapted to either measure an internal magnetic field $B_{int}$ caused by the on chip inductor element 5 or an external magnetic field $B_{ext}$ caused by an external coil or an external wire in the vicinity of the integrated chip 1.

In the embodiment illustrated in Fig. 1, the integrated circuit 1 comprises an overcurrent protection circuit 7 connected in series with the at least one on chip inductor element 5. The overcurrent protection circuit 7 keeps the electric current flowing through the on chip inductor element 6 within safe limits. Because of the limitation of the current planar technologies caused by electric migration rules where the electric current I flowing through a conductive layer wire is limited by the width of the respective wire, the electric current passed through the on chip inductor element 6 is kept by the overcurrent protection circuit 7 within the required safe limits or ranges. In the embodiment shown in Fig. 1, the overcurrent protection circuit 7 comprises a current sensing element 8 and a low resistance switch 9 connected in series with the on chip inductor element 5. The current sensing element 8 can be formed by an integrated resistor as illustrated in Fig. 1. A voltage drop at the current sensing element 8 is amplified by a voltage amplifier 10 of the overcurrent protection circuit 7 and the output of the voltage amplifier 10 is connected via a control signal line 11 to the low resistance switch 9 of the overcurrent protection circuit 7. If the voltage drop at the current sensing element 8 exceeds a threshold voltage $V_{TH}$, the voltage amplifier 10 is adapted to switch the low resistance switch 9 of the overcurrent protection circuit 7 off to interrupt the electric current flowing through said on chip inductor element 5. In a possible embodiment, the threshold voltage $V_{TH}$ can be a predetermined fixed threshold voltage. In an alternative embodiment, the threshold voltage $V_{TH}$ can be an adjustable and/or programmed threshold voltage. The overcurrent protection circuit 7 can in a possible embodiment be implemented in the same layer as the on chip inductor element 5 of the integrated circuit 1.

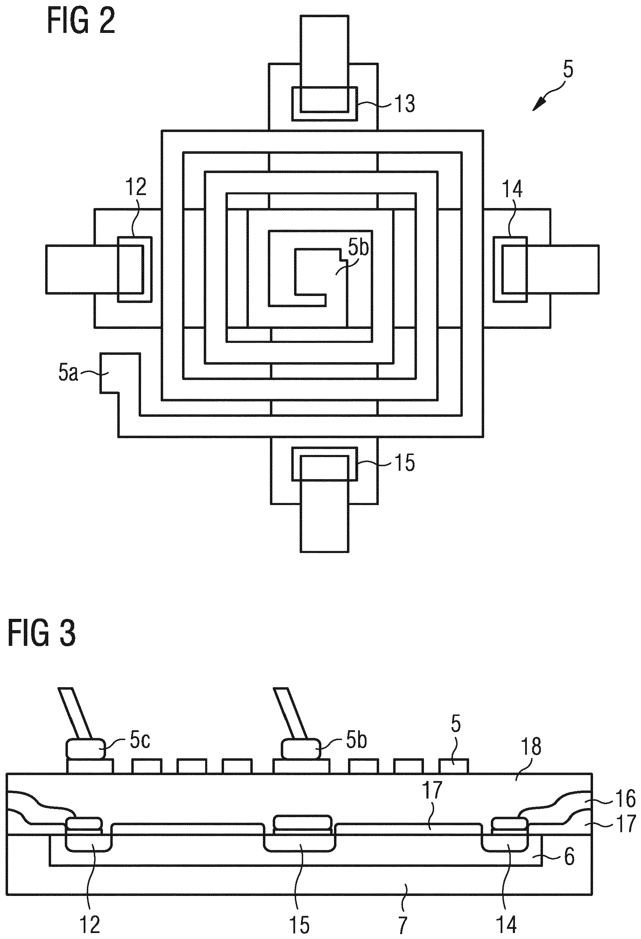

Fig. 2 illustrates a possible exemplary embodiment of an on chip inductor element 5 used in the integrated circuit 1 according to the present invention. In the embodiment shown in Fig. 1, the on chip inductor element 5 comprises a spiral form. The spiral on chip inductor element 5 as shown in Fig. 2 comprises two connection terminals 5A, 5B, wherein the first connection 5A connects the on chip inductor element 5 with the current sense pin 2 of the integrated chip 1 via an internal current line 4 as illustrated in Fig. 1. The other connection 5B of the on chip inductor element 5 connects the on chip inductor element 5 to the overcurrent protection circuit 7 as illustrated in Fig. 1. Beneath the on chip inductor element 5, the on chip Hall sensor plate 6 is located within another chip layer of the integrated circuit 1 as illustrated in the cross-section view of Fig. 3. As can be seen in Fig.

3, the on chip Hall sensor plate 6 can be implemented by a N-well cross structure placed in a p-type silicon substrate 7 of the integrated circuit 1. In a possible embodiment, the on chip Hall sensor plate 6 can comprise four highly doped n+ contact areas 12, 13, 14, 15 as illustrated in Figs. 2, 3. These highly doped n+ contact areas 12, 13, 14, 15 are connected in the illustrated embodiment to an interconnection metal layer 16 isolated by an isolation layer 17 from the p-type silicon substrate 7 of the integrated circuit. In a possible embodiment, the isolating layer can be formed by a $SiO_2$ isolating layer. The Hall sensor plate 6 and the metal layer 16 are covered by a passivation layer 18 which can be formed by $SiO_2$ or $Si_3N_4$. The on chip inductor element 5 formed by the spiral coil 5 can be implemented as a metal planar coil in spiral form and placed on the passivation layer 18 as illustrated in Fig. 3. In a possible embodiment, the on chip inductor element 5 is bonded to chip frame pads of the integrated circuit 1. In a further possible alternative embodiment, the on chip inductor element 5 is connected to an on chip metal interconnection layer by means of via contacts.

## Claims

1. An integrated circuit (1) comprising:

   at least one on chip Hall sensor plate (6) configured to measure an external magnetic field; and an on chip inductor element (5) connected to two current sense pins (2, 3) of said integrated circuit (1), wherein the on chip inductor element (5) is configured to generate an internal magnetic field sensed by said on chip Hall sensor plate (6) to measure an applied electrical current (I) flowing through said on chip inductor element (5) via said current sense pins (2, 3) of said integrated circuit (1); wherein the integrated circuit (1) further comprises:

      an overcurrent protection circuit (7) comprising a current sensing element (8) and a low resistance switch (9) connected in series with the on chip inductor element (5) ; wherein the circuit is configured such that a voltage drop at the current sensing element (8) is amplified by a voltage amplifier (10) adapted to control the low resistance switch (9) of the overcurrent protection circuit (7); and wherein, if the voltage drop at the current sensing element (8) exceeds a threshold voltage, the voltage amplifier (10) is configured to switch the low resistance switch (9) off to interrupt a current flow through said on chip inductor element (5); **characterized in that** the on chip inductor element (5) is formed by a metal planar coil on a passivation layer (18) covering the on chip Hall sensor plate (6) and an interconnection metal layer (16).

2. The integrated circuit according to claim 1, wherein the on chip inductor element (5) comprises a rectangular or spiral form.

3. The integrated circuit according to claim 1 or 2, wherein the on chip inductor element (5) and the Hall sensor plate (6) are provided at different layers of the integrated circuit (1) providing a predetermined distance between the on chip inductor element (5) and the Hall sensor plate (6).

4. The integrated circuit according to claim 1, wherein the threshold voltage comprises a predetermined threshold voltage or an adjustable and/or programmed threshold voltage.

5. The integrated circuit according to one of the preceding claims 1 to 4, wherein the current sensing element (8) of the overcurrent protection circuit (7) is an integrated resistor.

6. The integrated circuit according to one of the preceding claims 1 to 5, wherein the on chip Hall sensor plate (6) is implemented by a N-well cross structure placed in a p-type silicon substrate of the integrated circuit (1).

7. The integrated circuit according to claim 6, wherein the on chip Hall sensor plate (6) comprises four highly doped n+ contact areas (12, 13, 14, 15) connected to an interconnection metal layer of said integrated circuit (1) isolated by an isolating layer from the p-type silicon substrate of said integrated circuit (1).

8. The integrated circuit according to one of the preceding claims 6 or 7, wherein the on chip inductor element (5) is bonded to chip frame pads of said integrated circuit (1) or connected to an on chip metal interconnection layer by via contacts.

9. The integrated circuit according to one of the preceding claims 1 to 8, wherein the on chip Hall sensor plate (6) is configured to generate a Hall voltage being linear dependent on the magnetic field strength of the internal magnetic field caused by the electrical current (I) flowing through said on chip inductor element (5).

10. The integrated circuit according to claim 9, wherein the generated Hall voltage is processed by a processing unit to measure the electrical current (I) flowing through said on chip inductor element (5) of said integrated chip (1) .

11. An integrated circuit (1) comprising:

    at least one on chip Hall sensor plate (6) configured to measure an external magnetic field; and an on chip inductor element (5) connected to two current sense pins (2, 3) of said integrated circuit (1), wherein the on chip inductor element (5) is configured to generate an internal magnetic field sensed by said on chip Hall sensor plate (6) to measure an applied electrical current (I) flowing through said on chip inductor element (5) via said current sense pins (2, 3) of said integrated circuit (1);
    wherein the integrated circuit (1) further comprises:

       an overcurrent protection circuit (7) comprising a current sensing element (8) and a low resistance switch (9) connected in series with the on chip inductor element (5) ; wherein a voltage drop at the current sensing element (8) is amplified by a voltage amplifier (10) adapted to control the low resistance switch (9) of the overcurrent protection circuit (7);
       **characterized in that** the on chip Hall sensor plate (6) is implemented by a N-well cross structure placed in a p-type silicon substrate of the integrated circuit (1);
       wherein the on chip Hall sensor plate (6) comprises four highly doped n+ contact areas (12, 13, 14, 15) connected to an interconnection metal layer of said integrated circuit (1) isolated by an isolating layer from the p-type silicon substrate of said integrated circuit (1); and
       wherein the on chip inductor element (5) is formed by a metal planar coil on a passivation layer (18) covering the on chip Hall sensor plate (6) and the interconnection metal layer.

12. The integrated circuit according to claim 11, wherein the on chip inductor element (5) is bonded to chip frame pads of said integrated circuit (1) or connected to an on chip metal interconnection layer by via contacts.

13. The integrated circuit according to one of the preceding claims 11 or 12, wherein the on chip Hall sensor plate (6) is configured to generate a Hall voltage being linear dependent on the magnetic field strength of the internal magnetic field caused by the electrical current (I) flowing through said on chip inductor element (5).

14. The integrated circuit according to claim 13, wherein the generated Hall voltage is processed by a processing unit to measure the electrical current (I) flowing through said on chip inductor element (5) of said integrated chip (1) .

## Patentansprüche

1.  Integrierter Schaltkreis (1), umfassend:

    mindestens eine On-Chip-Hallsensorplatte (6), die dafür ausgestaltet ist, ein externes Magnetfeld zu messen; und
    ein On-Chip-Induktorelement (5), das mit zwei Stromabfühlstiften (2, 3) des integrierten Schaltkreises (1) verbunden ist, wobei das On-Chip-Induktorelement (5) dafür ausgestaltet ist, ein internes Magnetfeld zu erzeugen, das durch die On-Chip-Hallsensorplatte (6) abgefühlt wird, um einen angelegten elektrischen Strom (I), der durch das On-Chip-Induktorelement (5) fließt, über die Stromabfühlstifte (2, 3) des integrierten Schaltkreises (1) zu messen;
    wobei der integrierte Schaltkreis (1) des Weiteren Folgendes umfasst:

    einen Überstrom-Schutzkreis (7), der ein Stromabfühlelement (8) und einen widerstandsarmen Schalter (9) umfasst, die mit dem On-Chip-Induktorelement (5) in Reihe geschaltet sind;
    wobei der Schaltkreis so ausgestaltet ist, dass ein Spannungsabfall an dem Stromabfühlelement (8) durch einen Spannungsverstärker (10) verstärkt wird, der dafür ausgelegt ist, den widerstandsarmen Schalter (9) des Überstrom-Schutzkreises (7) zu steuern; und
    wobei, wenn der Spannungsabfall an dem Stromabfühlelement (8) eine Schwellenspannung übersteigt, der Spannungsverstärker (10) dafür ausgestaltet ist, den widerstandsarmen Schalter (9) auszuschalten, um einen Stromfluss durch das On-Chip-Induktorelement (5) zu unterbrechen; **dadurch gekennzeichnet, dass** das On-Chip-Induktorelement (5) von einer planaren Metallspule auf einer Passivierungsschicht (18) gebildet ist, welche die On-Chip-Hallsensorplatte (6) und eine Zwischenverbindungsmetallschicht (16) bedeckt.

2.  Integrierter Schaltkreis nach Anspruch 1, wobei das On-Chip-Induktorelement (5) eine Rechteck- oder Spiralform aufweist.

3.  Integrierter Schaltkreis nach Anspruch 1 oder 2, wobei das On-Chip-Induktorelement (5) und die Hallsensorplatte (6) auf unterschiedlichen Schichten des integrierten Schaltkreises (1) angeordnet sind, wodurch eine zuvor festgelegte Distanz zwischen dem On-Chip-Induktorelement (5) und der Hallsensorplatte (6) entsteht.

4.  Integrierter Schaltkreis nach Anspruch 1, wobei die Schwellenspannung eine zuvor festgelegte Schwellenspannung oder eine einstellbare und/oder programmierte Schwellenspannung umfasst.

5.  Integrierter Schaltkreis nach einem der vorangehenden Ansprüche 1 bis 4, wobei das Stromabfühlelement (8) des Überstrom-Schutzkreises (7) ein integrierter Widerstand ist.

6.  Integrierter Schaltkreis nach einem der vorangehenden Ansprüche 1 bis 5, wobei die On-Chip-Hallsorplatte (6) durch eine N-Mulden-Querstruktur implementiert wird, die in einem Siliziumsubstrat vom p-Typ des integrierten Schaltkreises (1) angeordnet ist.

7.  Integrierter Schaltkreis nach Anspruch 6, wobei die On-Chip-Hallsensorplatte (6) vier stark-dotierte "n+"-Kontaktbereiche (12, 13, 14, 15) umfasst, die mit einer Zwischenverbindungsmetallschicht des integrierten Schaltkreises (1) verbunden sind, die durch eine Isolierschicht vom dem Siliziumsubstrat vom p-Typ des integrierten Schaltkreises (1) isoliert ist.

8.  Integrierter Schaltkreis nach einem der vorangehenden Ansprüche 6 oder 7, wobei das On-Chip-Induktorelement (5) an Chip-Rahmen-Kontaktinseln des integrierten Schaltkreises (1) gebondet ist oder über Durchkontaktierungskontakte mit einer On-Chip-Metall-Zwischenverbindungsschicht verbunden ist.

9.  Integrierter Schaltkreis nach einem der vorangehenden Ansprüche 1 bis 8, wobei die On-Chip-Hallsensorplatte (6) dafür ausgestaltet ist, eine Hall-Spannung zu erzeugen, die in Abhängigkeit von der Magnetfeldstärke des internen Magnetfeldes, das durch den elektrischen Strom (I) verursacht wird, der durch das On-Chip-Induktorelement (5) fließt, linear ist.

10. Integrierter Schaltkreis nach Anspruch 9, wobei die erzeugte Hall-Spannung durch eine Verarbeitungseinheit verarbeitet wird, um den elektrischen Strom (I) zu messen, der durch das On-Chip-Induktorelement (5) des integrierten Chips (1) fließt.

11. Integrierter Schaltkreis (1), umfassend:

    mindestens eine On-Chip-Hallsensorplatte (6), die dafür ausgestaltet ist, ein externes Magnetfeld zu messen; und

ein On-Chip-Induktorelement (5), das mit zwei Stromabfühlstiften (2, 3) des integrierten Schaltkreises (1) verbunden ist, wobei das On-Chip-Induktorelement (5) dafür ausgestaltet ist, ein internes Magnetfeld zu erzeugen, das durch die On-Chip-Hallsensorplatte (6) abgefühlt wird, um einen angelegten elektrischen Strom (I), der durch das On-Chip-Induktorelement (5) fließt, über die Stromabfühlstifte (2, 3) des integrierten Schaltkreises (1) zu messen;

wobei der integrierte Schaltkreis (1) des Weiteren Folgendes umfasst:

> einen Überstrom-Schutzkreis (7), der ein Stromabfühlelement (8) und einen widerstandsarmen Schalter (9) umfasst, die mit dem On-Chip-Induktorelement (5) in Reihe geschaltet sind;
>
> wobei ein Spannungsabfall an dem Stromabfühlelement (8) durch einen Spannungsverstärker (10) verstärkt wird, der dafür ausgelegt ist, den widerstandsarmen Schalter (9) des Überstrom-Schutzkreises (7) zu steuern; und
>
> **dadurch gekennzeichnet, dass** die On-Chip-Hallsensorplatte (6) durch eine N-Mulden-Querstruktur implementiert wird, die in einem Siliziumsubstrat vom p-Typ des integrierten Schaltkreises (1) angeordnet ist;
>
> wobei die On-Chip-Hallsensorplatte (6) vier stark-dotierte "n+"-Kontaktbereiche (12, 13, 14, 15) umfasst, die mit einer Zwischenverbindungsmetallschicht des integrierten Schaltkreises (1) verbunden sind, die durch eine Isolierschicht vom dem Siliziumsubstrat vom p-Typ des integrierten Schaltkreises (1) isoliert ist; und
>
> wobei das On-Chip-Induktorelement (5) von einer planaren Metallspule auf einer Passivierungsschicht (18) gebildet ist, welche die On-Chip-Hallsensorplatte (6) und die Zwischenverbindungsmetallschicht bedeckt.

**12.** Integrierter Schaltkreis nach Anspruch 11, wobei das On-Chip-Induktorelement (5) an Chip-Rahmen-Kontaktinseln des integrierten Schaltkreises (1) gebondet ist oder über Durchkontaktierungskontakte mit einer On-Chip-Metall-Zwischenverbindungsschicht verbunden ist.

**13.** Integrierter Schaltkreis nach einem der vorangehenden Ansprüche 11 oder 12, wobei die On-Chip-Hallsensorplatte (6) dafür ausgestaltet ist, eine Hall-Spannung zu erzeugen, die in Abhängigkeit von der Magnetfeldstärke des internen Magnetfeldes, das durch den elektrischen Strom (I) verursacht wird, der durch das On-Chip-Induktorelement (5) fließt, linear ist.

**14.** Integrierter Schaltkreis nach Anspruch 13, wobei die erzeugte Hall-Spannung durch eine Verarbeitungseinheit verarbeitet wird, um den elektrischen Strom (I) zu messen, der durch das On-Chip-Induktorelement (5) des integrierten Chips (1) fließt.

**Revendications**

**1.** Circuit intégré (1) comprenant :

> au moins une plaque formant capteur à effet Hall sur puce (6) conçue pour mesurer un champ magnétique externe ; et
> un élément d'induction sur puce (5) connecté à deux broches de détection de courant (2, 3) dudit circuit intégré (1), dans lequel l'élément d'induction sur puce (5) est conçu pour engendrer un champ magnétique interne détecté par ladite plaque formant capteur à effet Hall sur puce (6) afin de mesurer un courant électrique appliqué (I) parcourant ledit élément d'induction sur puce (5) par le biais desdites broches de détection de courant (2, 3) dudit circuit intégré (1) ;
> dans lequel le circuit intégré (1) comprend en outre :
>
> > un circuit de protection contre les surintensités (7) comprenant un élément de détection de courant (8) et un interrupteur à faible résistance (9) connectés en série à l'élément d'induction sur puce (5) ;
> > dans lequel le circuit est conçu de manière qu'une chute de tension au niveau de l'élément de détection de courant (8) soit amplifiée par un amplificateur de tension (10) destiné à commander l'interrupteur à faible résistance (9) du circuit de protection contre les surintensités (7) ; et
> > dans lequel, si la chute de tension au niveau de l'élément de détection de courant (8) dépasse une tension de seuil, l'amplificateur de tension (10) est conçu pour mettre l'interrupteur à faible résistance (9) à l'état bloqué afin d'interrompre une circulation de courant à travers ledit élément d'induction sur puce (5) ;
> > **caractérisé en ce que** l'élément d'induction sur puce (5) est constitué d'une bobine métallique plane sur une couche de passivation (18) recouvrant la plaque formant capteur à effet Hall sur puce (6) et une couche métallique d'interconnexion (16).

**2.** Circuit intégré selon la revendication 1, dans lequel l'élément d'induction sur puce (5) comprend une forme rectangulaire ou spiralée.

3. Circuit intégré selon la revendication 1 ou 2, dans lequel l'élément d'induction sur puce (5) et la plaque formant capteur à effet Hall (6) se trouvent au niveau de couches différentes du circuit intégré (1), ce qui ménage une distance prédéterminée entre l'élément d'induction sur puce (5) et la plaque formant capteur à effet Hall (6).

4. Circuit intégré selon la revendication 1, dans lequel la tension de seuil comprend une tension de seuil prédéterminée ou une tension de seuil réglable et/ou programmée.

5. Circuit intégré selon l'une des revendications 1 à 4 précédentes, dans lequel l'élément de détection de courant (8) du circuit de protection contre les surintensités (7) est une résistance intégrée.

6. Circuit intégré selon l'une des revendications 1 à 5 précédentes, dans lequel la plaque formant capteur à effet Hall sur puce (6) est mise en oeuvre par une structure transversale à N puits, placée sur un substrat en silicium de type P du circuit intégré (1).

7. Circuit intégré selon la revendication 6, dans lequel la plaque formant capteur à effet Hall sur puce (6) comprend quatre zones de contact fortement dopées du type N+ (12, 13, 14, 15) reliées à une couche métallique d'interconnexion dudit circuit intégré (1), isolée du substrat en silicium du type P dudit circuit intégré (1) par une couche isolante.

8. Circuit intégré selon l'une des revendications 6 et 7 précédentes, dans lequel l'élément d'induction sur puce (5) est fixé à des plages d'accueil de châssis de puce dudit circuit intégré (1) ou relié à une couche métallique d'interconnexion sur puce au moyen de contacts par trous d'interconnexion.

9. Circuit intégré selon l'une des revendications 1 à 8 précédentes, dans lequel la plaque formant capteur à effet Hall sur puce (6) est conçue pour engendrer une tension de Hall qui est linéairement dépendante de l'excitation magnétique du champ magnétique interne causé par le courant électrique (I) parcourant ledit élément d'induction sur puce (5).

10. Circuit intégré selon la revendication 9, dans lequel la tension de Hall engendrée est traitée par une unité de traitement pour mesurer le courant électrique (I) parcourant ledit élément d'induction sur puce (5) de ladite puce intégrée (1).

11. Circuit intégré (1) comprenant :

au moins une plaque formant capteur à effet Hall sur puce (6) conçue pour mesurer un champ magnétique externe ; et
un élément d'induction sur puce (5) connecté à deux broches de détection de courant (2, 3) dudit circuit intégré (1), dans lequel l'élément d'induction sur puce (5) est conçu pour engendrer un champ magnétique interne détecté par ladite plaque formant capteur à effet Hall sur puce (6) afin de mesurer un courant électrique appliqué (I) parcourant ledit élément d'induction sur puce (5) par le biais desdites broches de détection de courant (2, 3) dudit circuit intégré (1) ;
dans lequel le circuit intégré (1) comprend en outre :

un circuit de protection contre les surintensités (7) comprenant un élément de détection de courant (8) et un interrupteur à faible résistance (9) connectés en série à l'élément d'induction sur puce (5) ;
dans lequel une chute de tension au niveau de l'élément de détection de courant (8) est amplifiée par un amplificateur de tension (10) destiné à commander l'interrupteur à faible résistance (9) du circuit de protection contre les surintensités (7) ;
**caractérisé en ce que** la plaque formant capteur à effet Hall sur puce (6) est mise en oeuvre par une structure transversale à N puits, placée sur un substrat en silicium de type P du circuit intégré (1) ;
dans lequel la plaque formant capteur à effet Hall sur puce (6) comprend quatre zones de contact fortement dopées du type N+ (12, 13, 14, 15) reliées à une couche métallique d'interconnexion dudit circuit intégré (1), isolée du substrat en silicium du type P dudit circuit intégré (1) par une couche isolante ; et
dans lequel l'élément d'induction sur puce (5) est constitué d'une bobine métallique plane sur une couche de passivation (18) recouvrant la plaque formant capteur à effet Hall sur puce (6) et la couche métallique d'interconnexion.

12. Circuit intégré selon la revendication 11, dans lequel l'élément d'induction sur puce (5) est fixé à des plages d'accueil de châssis de puce dudit circuit intégré (1) ou relié à une couche métallique d'interconnexion sur puce au moyen de contacts par trous d'interconnexion.

13. Circuit intégré selon l'une des revendications 11 et 12 précédentes, dans lequel la plaque formant capteur à effet Hall sur puce (6) est conçue pour engendrer une tension de Hall qui est linéairement dépendante de l'excitation magnétique du champ magnétique interne causé par le courant électrique (I) parcourant ledit élément d'induction sur puce (5).

14. Circuit intégré selon la revendication 13, dans lequel la tension de Hall engendrée est traitée par une unité de traitement pour mesurer le courant électrique (I) parcourant ledit élément d'induction sur puce (5) de ladite puce intégrée (1).

# FIG 1

# FIG 2

# FIG 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090001964 A1
- US 20060061350 A1
- US 5023684 A
- US 7075287 A

**Non-patent literature cited in the description**

- **EL-HALIM et al.** Practical Methodology of Control and Protection of Field Oriented Induction Machine Using Digital Signal Processing. *Computer Theory and Applications,* 2012, 122-126